# EUROPEAN PATENT SPECIFICATION

(11) **EP 0 516 425 B1**
(45) Date of publication and mention of the grant of the patent: **26.08.1998**
(21) Application number: 92304855.7
(22) Date of filing: 28.05.1992
(51) Int. Cl.: H01J 37/32, C23C 14/32

(54) **Cathodic arc deposition system and a method of controlling same**
Beschichtungsanlage mittels Kathodenzerstäubung und Methode zur Steuerung derselben
Système de dépôt par pulvérisation cathodique et une méthode de commande pour ce système

(30) Priority: 29.05.1991 JP 125954/91; 29.05.1991 JP 125953/91
(43) Date of publication of application: 02.12.1992
(73) Proprietor: KABUSHIKI KAISHA KOBE SEIKO SHO also known as Kobe Steel Ltd., Kobe 651 (JP)
(72) Inventor: Munemasa, Jun, c/o Kobe Steel, Ltd., Kobe-shi, Hyogo 651 (JP); Kumakiri, Tadashi, c/o Kobe Steel, Ltd., Kobe-shi, Hyogo 651 (JP); Tanaka, Tatsuya, c/o Kobe Steel, Ltd., Kobe-shi, Hyogo 651 (JP)
(74) Representative: BROOKES & MARTIN

(56) References cited:
- EP-A- 158 972
- EP-A- 277 341
- US-A- 4 556 471
- PATENT ABSTRACTS OF JAPAN vol. 12, no. 126 (M-687)19 April 1988 & JP-A-62 252 679 ( MITSUBISHI ) 4 November 1987
- PATENT ABSTRACTS OF JAPAN vol. 9, no. 171 (C-291)16 July 1985 & JP-A-60 043 482 ( FUJITSU ) 8 March 1985

## Description

The present invention relates to a cathodic arc deposition system used for making a coating, for example, an abrasion resistant film composed of TiN or the like, on the surface, e.g., of tool steel, and to a method of controlling such a system.

A cathodic arc deposition system (also referred to as a vacuum arc ion plating system) is adapted to deposit an ionized film-forming material on to a surface of a workpiece (hereinafter referred to as a substrate) applied with a negative bias voltage by evaporating the film-forming material from an evaporation surface of a cathode by means of arc discharge and ionizing the material, in a vacuum chamber. In this case, since an arc spot is formed on the evaporation surface of the cathode by arc discharge, which moves around at random while accompanying violent evaporation and ionization of the cathode material a shield is needed to prevent the arc spot from transferring from the evaporation surface of the cathode to a non-evaporation surface (such as a circumferential side of the cathode).

A system having an arc evaporation source comprising a cathode or the like provided with a shield for preventing the transfer of the arc spot and adapted to evaporate the cathode substance and deposit it on the surface of a substrate by the arc discharge is known, for example, as disclosed in Japanese patent Publication Sho 52-14690. Figure 9 is an explanatory cross-sectional view representing the arc evaporation source in a cathodic metal arc deposition system as in the prior art.

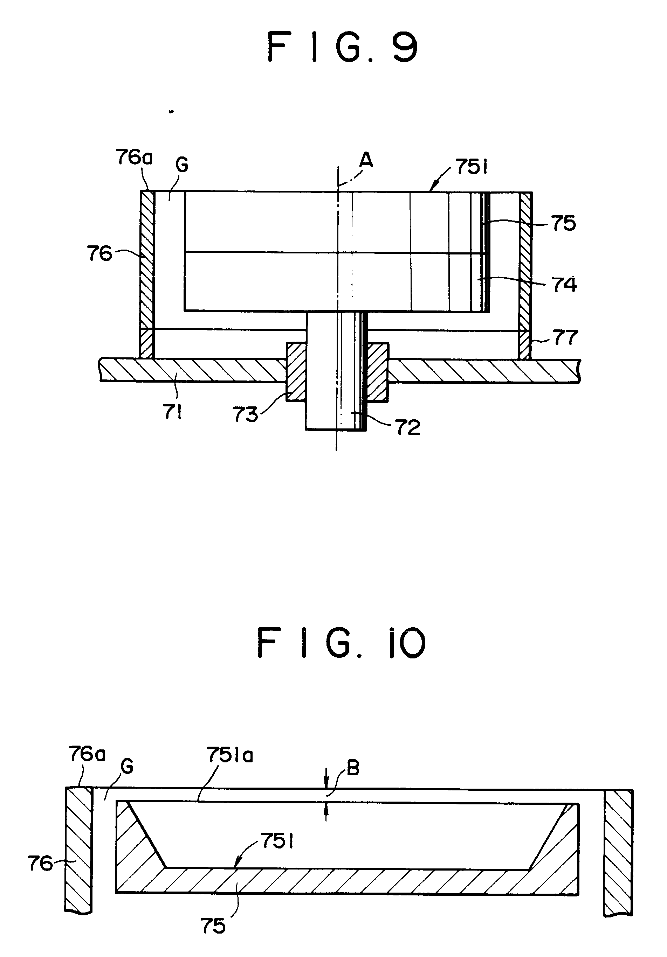

In Figure 9, a vacuum chamber 71, contains a cylindrical conductor 72 having an axis A. The conductor 72 is partly surrounded by a ceramic insulator 73 with an upper portion of the conductor 72 projecting inside the chamber 71. An electroconductive cooling bed 74 of disc-like form which is cooled at the inside is fixed to the upper surface of the conductor 72 inside the chamber 71 and a disc-shaped cathode 75 is fixed to the upper surface of the cooling bed 74. The cooling bed 74 and the cathode 75 are disposed on the conductor 72 with their axes aligned with the axis A. The cathode 75 is made of a metal material for forming a film, and the upper surface thereof constitutes an evaporation surface 751. A cylindrical shield 36 with an axis aligned with the axis A surrounds the circumferential edge of the cathode 75 at a gap G of about 2 to 3 mm. The shield 76 is fixed by way of an insulator 77 to the vacuum chamber 71.

The shield 76 is set such that the height of its upper edge 76a is identical with the height of an evaporation surface 751 before operation. If the upper edge 76a of the shield 76 is higher than the evaporation surface 751, evaporated metal is deposited on the shield 76 to fill the gap G thereby causing transfer of the arc spot to the shield 76. On the other hand, if the upper edge 76a is lower than the evaporation surface 751, the arc spot can be formed on a portion not surrounded with the shield 76 to cause evaporation of the cathode metal in this portion and, as a result, the gap G is short-circuited to also transfer the arc spot to the shield 76. It is thus necessary to keep the upper edge of the shield 76 and the evaporation surface 751 of the cathode 75 in alignment in order to maintain the arc discharge in a stable manner. However, as shown in Figure 10 which illustrates the state of the cathode consumption when the deposition operation is conducted for a long period of time, the evaporation surface 751 of the cathode 75 is gradually consumed and retracts concavely into a configuration having a bottom surface and a side wall. The upper surface 751a of the side wall of the evaporation surface 751 is lower by dimension B than the upper edge 76a of the shield 76. Therefore, evaporated cathode metal is deposited on the inner surface near the upper edge 76a of the shield 76 to fill the gap G, by which the shield 76 and the cathode 75 are short circuited, so that the arc point transfers to the shield 76. The cathode substance that fills the gap G is then melted and re-evaporated by the arc to release the short-circuit between the shield 76 and the cathode 75, so that the arc discharge is temporarily halted from time to time making the arc discharge unstable. When arc disconnection occurs, a trigger electrode not illustrated must be actuated instantly to start the arc discharge again. As the evaporation surface of a cathode is consumed it is desirable to adjust the relative positions of the upper edge of the shield and the evaporation surface to make them substantially level. This has the effect of optimizing the life of the cathode and improving efficiency.

US-A-4556471 and JP-A-60043482 disclose cathodic deposition systems in which the shield is adjustable relative to the cathode. EP-A-0158972 and JP-A-60043482 disclose means for adjusting the cathode relative to the shield.

The present invention provides means for controlling this adjustment automatically, so as to achieve reliable operation of a cathodic deposition system with little or no aid from an operator.

In one aspect, the present invention provides a cathodic arc deposition system adapted to evaporate and ionize a cathode substance from an evaporation surface of a cathode made of a film-forming material by means of arc discharge and to ionize the same for deposit on to the surface of a substrate; said system comprising an arc evaporation source having said cathode, a trigger electrode for restarting the arc when the arc is stopped, a cylindrical shield surrounding the cathode with a gap therebetween aligned and disposed such that the upper edge thereof is substantially at an identical height with that of the evaporation surface of said cathode, a detection device for detecting a number of arc stoppages per unit time of said arc discharge which outputs a detection signal when said arc stoppage number reaches a predetermined number, and a mechanism for moving at least either said cathode or said shield based on said cathode detection signal by a predetermined distance in the direction of decreasing the difference in the distance between the evaporation surface of said cathode and the upper edge of said shield.

In another aspect, the present invention provides a method of controlling a cathodic arc deposition system comprising a cathode made of a film-forming material, a shield for surrounding the cathode with a gap and a vacuum chamber containing said cathode and said shield, the system being adapted to depositing an ionized cathode substance on the surface of a substrate by evaporating the cathode substance from an evaporation surface of said cathode by arc discharge in the chamber, said method comprising:
detecting the number of arc stoppages over a time period,
providing a detection signal when the detected arc stoppage number reaches a predetermined value, and
adjusting the relative position of an upper edge of said shield and the evaporation surface of said cathode based on said detection signal.

In a preferred embodiment of the present invention, the shield extends over a circumferential edge of the evaporation surface of said cathode. In this cathodic arc deposition system, a circumferential edge margin of the evaporation surface of the cathode, preferably of disc-like form in addition to the circumference of the cathode, is covered over. In this embodiment, the arc spot is not formed to the circumferential edge margin of the evaporation surface of the cathode and this margin is not consumed. Since the circumferential edge margin of the evaporation surface of the cathode is not subjected to the arc spot it is not consumed, even when the region of the evaporation surface formed within the circumferential edge margin of the evaporation surface is consumed and retracted due to a long time of operation. Thus the positional relationship between the shield and the circumferential edge of the cathode can be maintained constant, thereby maintaining a stable arc discharge, as well as utilizing the cathode to its full life.

The invention may be understood more readily and various other aspects and features of the invention may become apparent from consideration of the following description.

In the accompanying drawings:
Figure 1 is an explanatory view illustrating the outline for a first cathodic arc deposition system for use in the present invention;
Figure 2 is a cross-sectional explanatory view for the constitution of an arc evaporation source in the cathodic arc deposition system shown in Figure 1;
Figure 3 is a view illustrating the state of consumption of the cathode shown in Figure 2;
Figure 4 is an explanatory cross-sectional view for the constitution of a second arc evaporation source in a cathodic arc deposition system for use in the present invention;
Figure 5 is an explanatory cross sectional view for the constitution of third evaporation source for use in the present invention;
Figure 6 is a view illustrating the state of consumption of the cathode shown in Figure 5;
Figure 7 is an explanatory cross-sectional view for the constitution of a further arc evaporation source for use in the present invention;
Figure 8 is a graph illustrating an example of a relationship between an operation time after starting vapor deposition and the number of arc stoppages per one hour in the cathodic arc deposition system shown in Figure 7;
Figure 9 is a cross-sectional explanatory view for an arc evaporation source in a cathodic arc metal deposition system in the prior art;
Figure 10 is a view illustrating the state of consumption of the cathode shown in Figure 9 in the prior art.

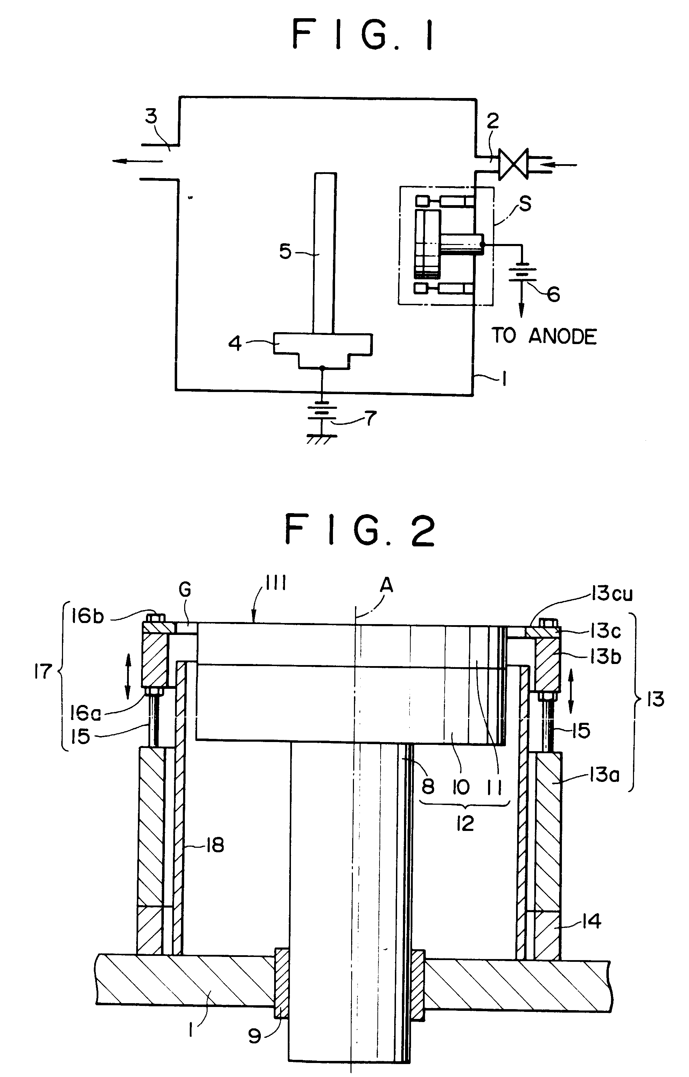

Figure 1 is an explanatory view illustrating the outline for a first embodiment of a cathodic arc deposition system for use in this invention,

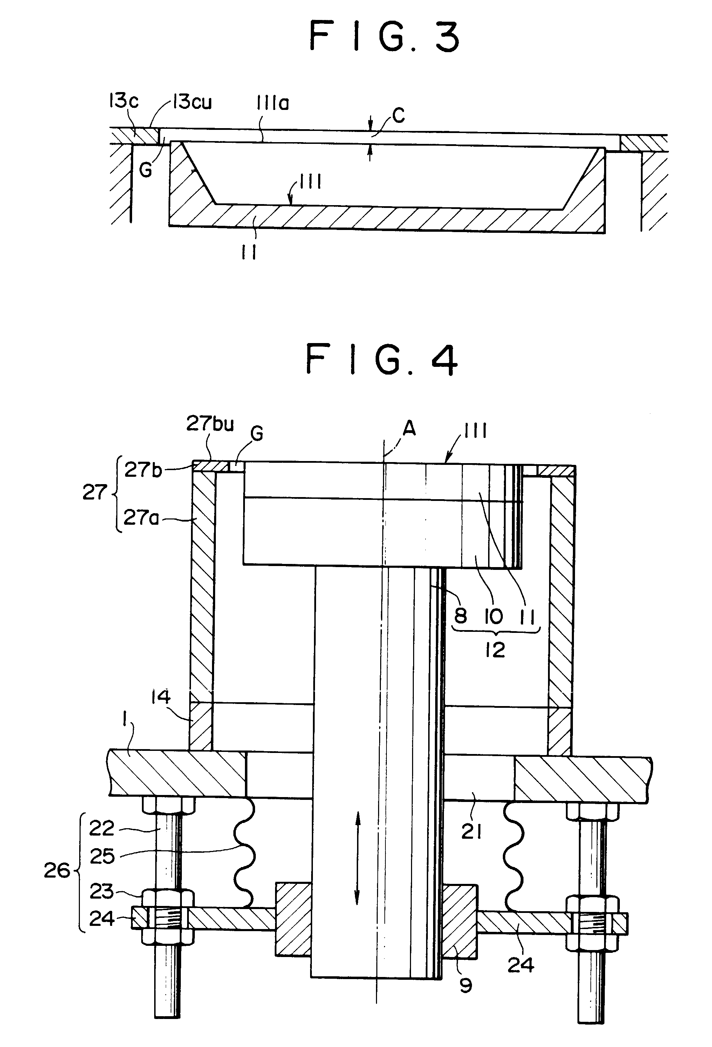

Figure 2 is an explanatory cross-sectional view for the constitution of an arc evaporation source in the cathodic arc deposition system shown in Figure 1 and Figure 3 is a view illustrating the state of consumption of the cathode shown in Figure 2.

In Figure 1, a vacuum chamber 1 has a gas introduction port 2 that introduces argon gas for maintaining arc discharge, and an exhaustion port 3 for evacuating the inside of the chamber by a vacuum pump (not illustrated). In this embodiment, an arc evaporation source S to be described later comprising, for example, a cathode provided with a shield for preventing arc spot transfer is attached to the side wall of the vacuum chamber 1. A rotational table 4 is disposed in the vacuum chamber 1, and a substrate 5 (specimen/workpiece) is placed on the rotational table 4 such that it opposes an evaporation surface of the cathode of the arc evaporation source S. An arc power source 6 serves for applying an arc creating voltage between the cathode of the arc evaporation source S and an anode (not illustrated) disposed in the vacuum chamber 1 with such a polarity as to render the cathode negative. A bias power supply 7 serves for applying a negative bias voltage to the substrate 5.

The constitution of the arc evaporation source S will now be described. As shown in Figure 2, a cylindrical conductor 8 having an axis A is attached by way of a ceramic insulator 9 to the vacuum chamber 1 with the upper region projecting inside the vacuum chamber 1. An electroconductive cooling bed 10 cooled at its inside is fixed to the upper surface of the conductor 8 to which is applied is a negative voltage from the arc power source 6. A disc-shaped cathode 11 made of a film-forming material and having an evaporation surface 111 formed on the upper surface is fixed to the upper surface of the cooling bed 10. The cooling bed 10 and the cathode 11 are disposed on the conductor 8, with their respective axes or center lines aligned with the axis A. The conductor 8, the cooling bed 10 and the cathode 11 constitute a cathode assembly 12.

A cylindrical lower shield 13a is fixed by way of an insulator 14 to the vacuum chamber 1 with its axis aligned with the axis A of the cathode 11. Stud bolts 15 are embedded, at the upper circumferential edge of the lower shield 13a at positions derived by dividing the circumference equally into six parts with the threaded portions extending upwards. To the stud bolts 15, are mounted a cylindrical upper shield 13b having an axis aligned with the axis A of the cathode 11 and having the same inner and outer diameters as those of the lower shield 13a. The shield 13b is provided with bolt reception holes for locating in a position to surround the circumferential edge of the cathode 11. A thin annular upper end shield 13c having an inner diameter smaller than that of the upper shield 13b is provided with bolt reception holes for the bolts 15. Lower nuts 16a for adjusting the height of the shield 13c are fitted on the bolts 15 at a lower predetermined distance from the upper edge of the lower shield 13a as shown. Both the shields 13b and 13c are secured by clamping upper nuts 16b on the bolts 15. The nuts 16a, 16b serve to adjust the height in such that the upper edge 13cu of the upper end shield 13c is opposed with a gap C to the circumferential edge of the cathode 11, at a height identical with the evaporation surface 111 of the cathode 11.

In this arrangement, the shield 13 is thus constituted by the lower shield 13a, the upper shield 13b and the upper end shield 13c. The stud bolts 15 and the nuts 16a, 16b for adjustment constitute a shield adjustment mechanism 17 for advancing and retracting the upper end shield 13c along the direction of the central axis A, so that the height of the upper edge 13cu of the upper end shield 13c can be made identical with the height of the evaporation surface 111 of the cathode 11. A cylindrical shielding plate 18 is disposed between the cathode assembly 12 and the shield 13 and secured to the vacuum chamber 1. The shielding plate 18 is used for shielding the stud bolts 15 from the cathode assembly 12. The arc evaporation source S is constituted by the cathode assembly 12, the shield 13, the shield adjustment mechanism 17 and the shield plate 18. The shield 13 can be made of steel. A trigger electrode for starting the arc is not illustrated.

The operation of the cathodic arc deposition system according to the first embodiment will now be described with reference to Figure 1 to Figure 3.

Before starting the operation of the system, the height for the upper edge 13cu of the upper end shield 13c is adjusted by the mechanism 17 such that the height thereof is identical with the height of the evaporation surface 111 of the cathode 11. In this case, the gap G between the upper end shield 13c and the circumferential edge of the cathode 11 is set to about 0.5 mm as a value at which arc discharge can be conducted most stably as a result of an experiment conducted under usual operation conditions of supplying an arc current of about 100 A. The thickness of the upper end shield 13c is appropriately about 2 mm.

After setting the height of the upper edge 13cu of the upper end shield 13c identical with the height of the evaporation surface 111 of the cathode 11, arc discharge is generated between the cathode 11 and the anode (not illustrated) in the vacuum chamber 1, by which the film-forming material is evaporated from the evaporation surface 111 of the cathode 11 and ionized simultaneously to deposit the ionized film-forming material on the surface of the substrate 5.

When the system is operated for a long period of time, and the cathode 11 is partly consumed, the evaporation surface 111 is retracted concavely into a shape having a bottom surface and a side wall, in which a difference C of the height is caused between the upper edge 13cu of the upper end shield 13c and the upper surface 111a of the side wall of the evaporation surface 111 as shown in Figure 3. Then, if the operation is continued further in this state, temporary arc disconnection occurs frequently to make the arc discharge unstable as described previously.

In view of the above, when the difference C of the height exceeds a predetermined value, for example, 0.5 mm, the height adjusting nuts 16a, 16b are loosened, and the upper shield 13b and the upper end shield 13c are retracted downward in the drawing until the height difference C described above is eliminated and, subsequently, the height adjusting nuts 16a, 16b are clamped. In this way, the height is adjusted such that the height for the upper edge 13cu of the upper end shield 13c is identical with the height for the upper surface 111a of the wall of the evaporation surface 111.

Adjustment for the height as described above can be repeated every time the height difference C between the upper surface 111a of the wall of the evaporation surface 111 and the upper edge 13cu of the upper end shield 13c exceeds a predetermined value. This enables a stable arc discharge to be maintained with arc disconnection, as well as usage of the cathode 11 as far as its full life without exchanging the cathode 11 as in the prior art.

Various design changes are possible for the shield adjusting mechanism 17 so long as the shield 13 or part thereof can be moved in the axial direction such that the height of the upper edge of the shield can be adjusted and made identical with the evaporation surface of the cathode.

A preferred embodiment of the present invention dill be described in connection with Figure 4 which is an explanatory cross-section view for constitution of an arc evaporation source in a second embodiment of cathodic arc deposition system for use in the present invention. Since the constitution of the second embodiment is identical with that of the first embodiment except for the difference in the constitution of the arc evaporation source, the following description will be made only for the differences in the constitution of the arc evaporation source, while features substantially in common with the first embodiment are indicated with identical reference numerals.

In Figure 4, a penetration hole 21 is formed in the vacuum chamber 1 and a plurality of stud bolts 22 are embedded in the circumferential wall surface of the vacuum chamber 1 at positions equally spaced around the axis of the penetration hole 21. The threaded portions of the bolts 22 protrude downwards as shown in the drawing. A cathode support plate 24 is supported and fixed to the bolts 22 by clamping nuts 23. The nuts 23 enable the height of the plate 24 to be adjusted. The cylindrical conductor 8 with the axis A is supported and secured by way of the ceramic insulator 9 to the cathode support plate 24 instead of the vacuum chamber 1 with the upper surface thereof projecting through the penetration hole 21 into the vacuum chamber 1.

The electroconductive cooling bed 10 cooled at the inside is fixed to the upper surface of the conductor 8 and the disc-shaped cathode 11 made of a film-forming material which the evaporation surface 111 formed on the upper surface is fixed to the upper surface of the cooling bed 10. The cooling bed 10 and the cathode 11 are disposed on the conductor 8 such that their respective axes are aligned with the axis A. The conductor 8, the cooling bed 10 and the cathode 11 constitute the cathode assembly 12.

Flexible bellows 25 are connected between the cathode support plate 23 and the chamber so as to surround the conductor 8. Thereby the inside of the vacuum chamber 1 is kept airtight. In this embodiment, the stud bolts 25, the height adjusting nuts 23, the cathode support plate 24 and the bellows 25 constitute a cathode adjustment mechanism 26 for moving the cathode 11 in the direction of the axis A thereof.

A cylindrical circumferential side shield 27a that surrounds the circumferential edge of the cathode 11, has an axis aligned with the axis A. The shield 27a is secured by way of the insulator 14 to the vacuum chamber 1. A thin annular upper end shield 27b having an inner diameter smaller than that of the shield 27a is secured to the shield 27a. The circumferential side shield 27a and the upper end shield 27b constitute a shield 27. The cathode assembly 12, the shield 27, and the cathode adjustment mechanism 26 constitute an arc evaporation source S. The operation of the cathodic arc deposition system having the foregoing constructional features will now be described as with reference to Figure 4.

Before staring the operation the height of the evaporation surface of the cathode 11 is adjusted with the mechanism 26 to align with the upper edge 27bu of the upper end shield 27b. Arc discharge is now commenced as before. When the system has operated for a long period of time, and the cathode 11 is partly consumed, the evaporation surface 111 retracts concavely into a shape having a bottom surface and a side wall. The upper surface of the side wall becomes lower than the upper edge 27bu of the upper end shield 27b, to cause a difference of the height between the upper edge 27bu and the upper surface of the wall of the evaporation surface 111 (refer to Figure 3). If the evaporation process is further continued in this state, temporary arc disconnection occurs frequently to make the arc discharge unstable as described previously. However, when the difference of the height between the edge 27bu and the surface 111 exceeds a predetermined value, for example, 0.5 mm, the height adjusting nuts 23 are loosened the cathode support plate 24 attached to the cathode assembly 12 is advanced upwardly and, subsequently, the height adjusting nuts 23 are clamped again, to adjust the height of the cathode 11 such that the height of the upper edge 27bu of the upper end shield 27b is identical with the height of the upper surface of the wall of the evaporation surface 111. Afterward, the adjustment of the height as described above is repeated every time the height difference between the upper surface of the wall of the evaporation surface 111 and the upper edge 27bu of the upper end shield 27b exceeds the predetermined value.

This enables stable discharge to be maintained without causing arc disconnection and utilizes the cathode 11 to its full life without requiring replacement of the cathode 11.

Various design changes are possible for the cathode adjustment mechanism 26 so long as the cathode 11 can be moved in the axial direction such that the height can be made identical between the evaporation surface 111 of the cathode 11 and the upper edge 27bu of the shield 27b.

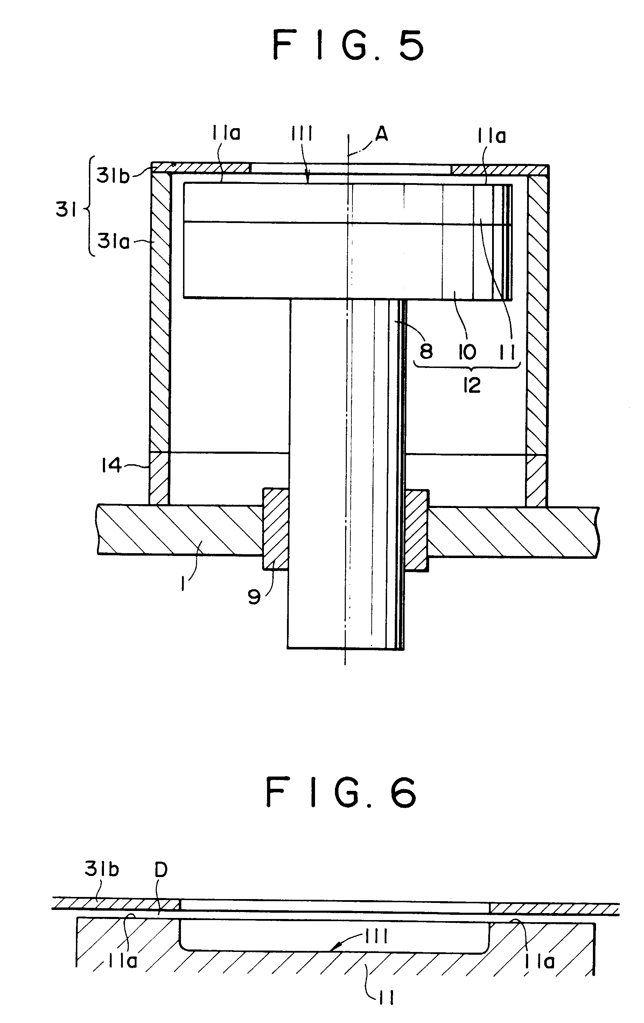

Figure 5 is an explanatory cross-sectional view of an arc evaporation source in a cathodic arc deposition system according to a third embodiment for use in the present invention. Since the constitution of the third embodiment is identical with that of the first embodiment except for the difference of the constitution for the arc evaporation source, the following description will be made only to the constitution of the arc evaporation source while those constructional features substantially in common with the first embodiment are indicated with identical reference numerals.

As shown in Figure 5, a circumferential side shield 31a is secured by way of the insulator 14 to a vacuum chamber 1 so as to surround the circumferential surface of the cathode 11 with the axis thereof being aligned with the axis A of the cathode 11. An annular edge shield 31b is attached to the circumferential side shield 31a. The edge shield 31b protrudes inward from the upper edge of the side circumferential shield 31a and covers the circumferential edge 11a of the evaporation surface of the cathode 11 at a predetermined gap D. The side circumferential shield 31a and the edge shield 31b constitute a shield 31. In this embodiment, the cathode assembly 12 comprises the conductor 8, the cooling bed 10 and the cathode 11, and this in combination with the shield 31 constitutes the arc evaporation source S.

The distance D between the circumferential edge 11a of the evaporation surface of the cathode 11 and the edge shield 31b is set to about 0.5 mm as a value at which arc discharge can be conducted most stably as a result of an experiment conducted under usual operation and conditions of supplying an arc current of about 100 A. Further, the thickness of the edge shield 31b is appropriately about 2 mm. Figure 6 illustrates the state of the cathode 11 after partial consumption.

When the system is operated, since the circumferential side of the cathode 11 and the circumferential edge 11a of the evaporation surface thereof are covered by the shield 31 at a gap, no arc spot is formed on the circumferential edge 11a of the evaporation surface but some portion inwardly of the circumferential edge 11a of the evaporation surface constitutes the evaporation surface 111. As shown in Figure 5, this enables the maintainance of a constant positional relationship between the edge shield 31b and the circumferential edge lla of the evaporation surface of the cathode 11 even when the evaporation surface 111 is retracted due the consumption, so that stable arc discharge can be maintained over the full life of the cathode 11 without conducting any height adjustment between the evaporation surface 111 and the shield edge 31b.

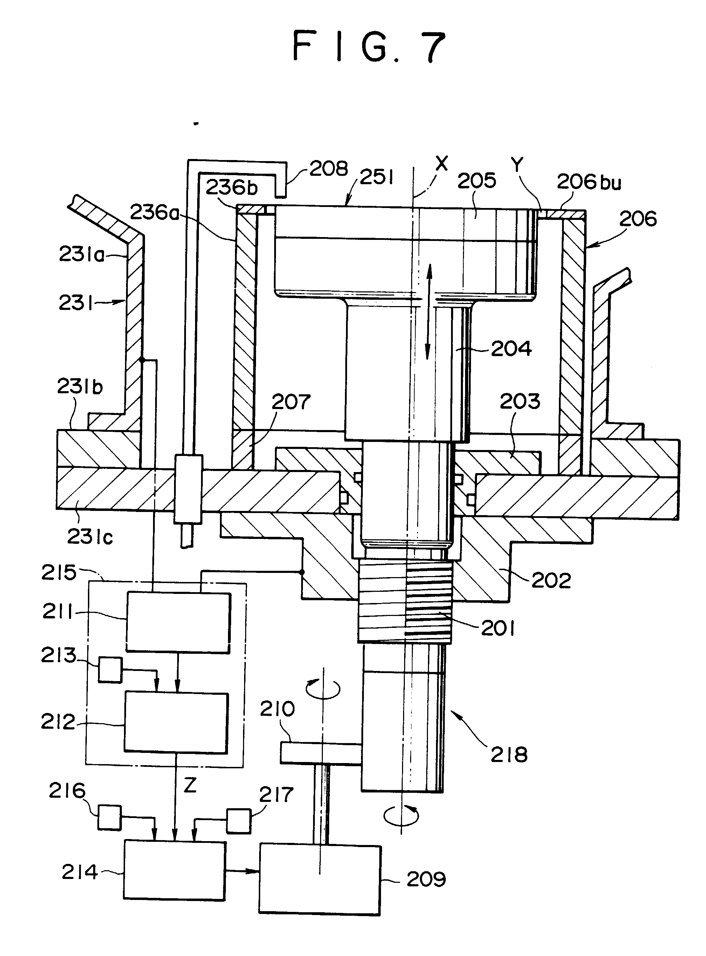

The present invention will now be fully described with reference to Figure 7 which is an explanatory view for the constitution of an arc evaporation source in a fourth embodiment of cathodic arc deposition system.

In Figure 7 a vacuum chamber 231 comprises a chamber main body 231a and a circumferential chamber side member 231c fixed by way of an insulation flange 231b to the chamber main body 231a to define an airtight chamber the inside of which is evacuated. As shown in the drawing, a chamber penetration hole is formed in the circumferential chamber side member 231c such that a rotational advancing/retracting shaft 201 can enter into and retract from the vacuum chamber 231. An electroconductive annular support plate 202 having a penetration hole formed with female threads is fixed to the circumferential chamber side member 231c at the outer surface for the position of the chamber penetration hole.

The shaft 201 has electroconductivity, is of cylindrical shape, and has male threads formed at a portion of the outer circumferential surface thereof for screw-coupling with the female threads of the penetration hole in the support plate 202. The shaft 201 is supported with the male thread screw-coupled with the female threads of the penetration hole in the support plate 202 and disposed, with the top end of the shaft extending into the inside of the vacuum camber 231. A seal member 203 is disposed between the shaft 201 and the side member 231c, such that air tightness in the vacuum chamber 231 can be maintained even when the shaft 201 enters into or retracts from the vacuum chamber 231.

An electroconductive cathode support conductor 204 is fixed at the top end of the shaft 201 and is connected with a negative terminal of a DC arc power supply (not illustrated), with the axis thereof aligned with the axis X of the shaft 201. A disc-shaped cathode 205 made of a film-forming metal material and having an evaporation surface 251 at the upper surface thereof is placed on the cathode support conductor 204 with the axis thereof aligned with the axis X. A cylindrical circumferential side shield 206a is secured by way of an insulator 207 to the side member 231 for surrounding the circumferential side of the cathode 205 and the cathode support conductor 204, with the axis thereof aligned with axis X of the cathode 205. An annular upper end shield 206b projects inwards from the upper circumferential edge of the shield 206 and is secured to the upper circumferential edge of the shield 206a so as to surround the circumferential side of the cathode 205 at a gap Y of about 0.5 mm. The shield 206a and the upper end shield 206b together constitute a shield 206.

A trigger 208 is used for starting the arc and is attached to the side member 231c with insulation and connected with an arc start circuit of the DC arc power supply (not illustrated).

A motor 209 serves for advancing and retracting the cathode 205 and is attached to a fixture disposed atthe outside of the vacuum chamber 231. A gear 210 is attached to a speed retarder shaft of the motor 209 and is insulated relative to the motor 209.

When the gear 210 is rotated by the motor 209 for advancing/retracting the cathode 205, the shaft 201 is rotated, and the cathode 205 is advanced or retracted vertically in the drawing while rotating at a low speed.

An arc stoppage voltage detection circuit 211 is inputted with a voltage between the chamber main body 231a and the support plate 202. The circuit 211 detects an abrupt increase of the voltage by about 60V, as compared with the normal voltage about 18V during arc discharge, when the arc discharge is stopped during the deposition operation. An arc stoppage pulse delivered by the circuit 211 is fed to a counter 212.

The counter 212, in this embodiment, counts the number of arc stoppages per one hour after starting the deposition and, when the counted value reaches a predetermined number N previously set by an arc stoppage number setter 213, gives a cathode evaporation surface retraction detection signal Z to a motor control circuit 214.

The arc stoppage voltage detection circuit 211, the counter 212 and the arc stoppage number setter 213 constitute an arc stoppage number detection device 215.

The motor control circuit 214 is used for the driving control of the cathode advancing/retracting motor 209 to advance or retract the cathode 205 by way of the shaft 201 along the vertical direction in the drawing. When the cathode evaporation surface retraction detection signal Z is given from the arc stoppage number detection device 215, the motor control circuit 214 controls the cathode advancing/retracting motor 209 so as to advance the cathode 205 by a previously set advancing distance d by an advancing distance setter 216. 217 denotes a device for driving the cathode advancing/retracting motor 209 by manual operation.

The shaft 201, the support plate 202, the seal member 203, the cathode support conductor 204, the cathode advancing and retracting motor 209, the gear 210, the motor control circuit 214, the advancing direction setter 216 and the manual operation device 217 all constitute a cathode adjustment mechanism 218.

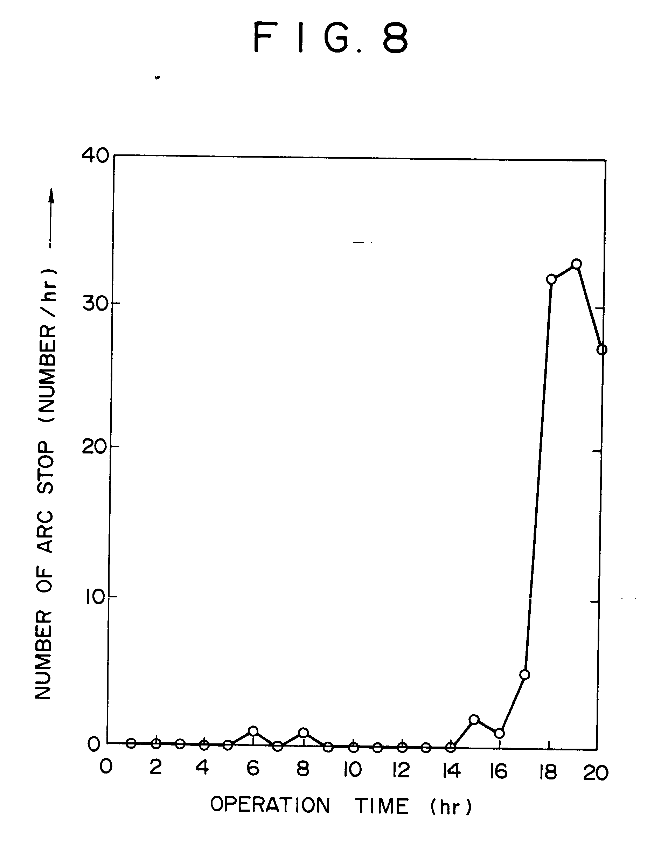

Figure 8 is a graph illustrating an example of a relationship between an operation time after starting the vapor deposition by the cathodic arc deposition system and a number of arc stoppages per one hour under standard conditions of an arc current of 100 A using a cathode made of Ti. The graph shows that the number of arc stoppages (number/hour) during a period from 18 hour to 19 hour after starting the deposition is significantly increased to greater than 30 as compared with the preceding period. In this case, the difference B for the height between the upper surface of the wall in the evaporation surface of the cathode and the upper edge of the shield (refer to Figure 10) is about 0.5 to 1mm.

Further, Figure 8 shows that there is a tendency in a period from 16 hour to 17 hour of the system operation time, before the extreme increase of the number of arc stoppages is increased from 5 - 10 as before.

The invention according to the third embodiment utilizes the foregoing data. In the arc evaporation source device of the cathodic arc deposition system according to the present invention, when deposition is started, a predetermined number of temporary arc stoppages per hour is detected by the arc stoppage detection device and the cathode evaporation surface retraction detection signal is given to the moving mechanism when the detected number of arc stoppages reaches a predetermined number. When the moving mechanism is operated upon receiving the signal, either the cathode or the shield is moved by a predetermined distance in the direction of decreasing the difference of the height between the evaporation surface of the cathode and the upper edge of the shield in the direction of the axial line. This decreases the difference for the height between the upper edge of the shield and the retracted evaporation surface of the cathode to prevent frequent arc stoppages. In Figure 8, reference is made to an example in which the number of arc stoppages is increased in a period from 16 hour to 17 hours after starting the operation as compared with before. A similarly tendency is shown also in other cases although the time till such a tendency is caused differs depending on the conditions such as substance for the cathode and the arc current.

The operation of the cathodic arc deposition system having the arc evaporation source of the foregoing constitution will now be described with reference to Figures 7 ahd 8. At first, prior to starting the operation of the system, the cathode advancing/retracting motor 209 is driven to position the upper surface of the evaporation surface 251 of the cathode 205 at a height identical with that of the upper edge 206bu of the shield 206. Further, the arc stoppage number N set by the arc stoppage number setter 213 is set as N = 10 and the advancing direction d set by the advancing direction setter 216 is set as d = 0.1 mm. Then, the operation is started to generate arc discharge, and the film-forming material is evaporated from the evaporation surface 251 of the cathode 205 and ionized at the same time to deposit the ionized cathode substance on the surface of a substrate. After the operation is started and the evaporation surface 251 of the cathode 205 is consumed and retracted concavely during the elapse of the operation time, the height for the upper surface of the wall of the evaporation surface 251 becomes progressively lower than the upper edge 206bu of the shield 206 and eventually the number of arc stoppages increases. When the number of arc stoppages per one hour reaches the set number of arc stoppages: N = 10, the cathode evaporation surface retraction detection signal Z is inputted from the counter 212 to the motor control circuit 214.

This drives the cathode advancing/retracting motor 209 and the cathode 205 is advanced, by d = 0.1 mm in this embodiment. The difference of the height between the upper edge 206bu of the shield and the upper surface of the wall of the evaporation surface 251 is thus decreased. As a result of repeating such control during operation of the system, even if the evaporation surface 251 of the cathode 205 is retracted due to long operation time the difference of the height between the upper edge 206bu of the shield and the upper surface of the wall in the cathode evaporation surface 251 is reduced, before the occurrence of frequent arc stoppages, for example, more than 30 times per one hour. Stable arc discharge is then maintained without causing frequent arc stoppages and the life of the cathode 205 is increased. Further, the monitoring operation for the state of arc discharge by an operator is no more necessary so an arc ion plating system having the arc evaporation source according to the present invention can attain continuous reliable operation with little or no aid from an operator.

Although the cathode adjustment or moving mechanism 218 is exemplified in this embodiment in which the cathode 205 is advanced so as to decrease the difference in the height between the upper edge 206bu of the shield and the upper surface of the wall in the cathode evaporation surface 251 based on the cathode evaporation surface retraction detection signal Z, it may be of course be adapted such that the shield 206 is retracted in the axial direction, or both of the cathode 205 and the shield 206 are moved so as to reduce,the difference for the height between both of them, based on the cathode evaporation surface retraction detection signal Z.

The present invention can be practised in various other forms without departing from the principal features thereof as defined in the appended claims. Therefore, the foregoing embodiments are merely examples, and may be subject to modifications and changes within the scope of the claims.

## Claims

1. A cathodic arc deposition system adapted to evaporate and ionize a cathode substance from an evaporation surface (111) of a cathode (11) by means of arc discharge and to ionize the same for deposit on to the surface of a substrate (5); said system comprising:
an arc evaporation source (S) comprising a cathode (11, 205) made of a film-forming material, a trigger electrode (208) for restarting the arc when the arc is stopped and a cylindrical shield (13, 31, 206) surrounding the cathode with a gap (C, D, Y) therebetween aligned and disposed such that the upper edge (13cu, 27bu, 31bu, 206bu) thereof is substantially at an identical height with that of the evaporation surface (111) of said cathode;
characterized in that a detection device (211) is provided for detecting the number of arc stoppages per unit time of said arc discharge and outputting a detection signal when said arc stoppage number reaches a predetermined number, and an adjusting means (209) is provided for moving at least either said cathode or said shield based on said detection signal by a predetermined distance in the direction of decreasing the difference in the distance between the evaporation surface of said cathode and the upper edge of said shield.

2. A deposition system as claimed in claim 1, wherein the adjusting means is adapted to move a cathode support plate (24) attached to a conductor (8) supporting the cathode (11) and include adjusting nuts (23) for mounting the support plate on stud bolts (22).

3. A deposition system as claimed in claim 2, wherein bellows (25) are provided between the cathode support plate (24) and the vacuum chamber (1).

4. A deposition system as claimed in claim 1, wherein the adjusting means for moving the cathode comprises a rotational advancing/retracting shaft (201) disposed below the cathode and an annular support plate (202) screw-coupled with the shaft (20) and secured to the vacuum chamber (231), whereby adjustment is effected by rotating said shaft.

5. A deposition system as claimed in any one of claims 1 to 4, wherein the shield (31b) extends over a circumferential edge of the evaporation surface (111) of said cathode.

6. A deposition system as claimed in claim 5, wherein the cathode and the shield are co-axial, the shield has a cylindrical portion (31a) surrounding the circumference of the cathode (11) with the gap therebetween and an edge shield portion (31b) protrudes inwardly from an upper edge of the cylindrical shield portion (31a) to overlap with a circumferential margin of the evaporation surface (111) from above.

7. A method of controlling a cathodic arc deposition system comprising a cathode (11, 205) made of a film-forming material, a shield (13, 27, 31, 206) for surrounding the cathode with a gap (C,D,Y) and a vacuum chamber (1, 231) containing said cathode and said shield, the system being adapted to deposit ionized cathode substance on the surface of a substrate by evaporating the cathode substance from an evaporation surface (111) of said cathode by arc discharge in the chamber, characterized by
detecting the number of arc stoppages over a time period,
providing a detection signal (Z) when the detected arc stoppage number reaches a predetermined value, and
adjusting the relative position of an upper edge of said shield and the evaporation surface of said cathode based on said detection signal.

## Patentansprüche

1. Ein Kathodenzerstäubungsbeschichtungssystem, das dazu angepaßt ist, eine Kathodensubstanz von einer Verdampfungsoberfläche (111) einer Kathode (11) mittels einer Lichtbogenentladung zu verdampfen und zu ionisieren und um dieselbe zur Beschichtung auf die Oberfläche eines Substrats (5) zu ionisieren, wobei das System folgendes aufweist:
eine Lichtbogenverdampfungsquelle (S), aufweisend eine Kathode (11, 205), die aus einem filmerzeugenden Material hergestellt ist, eine Triggerelektrode (208) zum Wiederstarten des Lichtbogens, wenn der Lichtbogen gestoppt wurde und ein zylindrisches Schutzschild (13, 31, 206), das die Kathode mit einem Spalt (C, D, Y) dazwischen umgibt, das so ausgerichtet und angeordnet ist, daß die obere Kante (13cu, 27bu, 31bu, 206bu) davon im Wesentlichen in einer identischen Höhe zu jener der Verdampfungsoberfläche (111) der Kathode ist;
dadurch gekennzeichnet, daß eine Erfassungsvorrichtung (211) zur Erfassung der Anzahl an Lichtbogenstops der Lichtbogenentladung pro Zeiteinheit und zum Abgeben eines Erfassungssignals, wenn die Lichtbogenstopanzahl eine vorbestimmte Anzahl erreicht, vorgesehen ist, und daß eine Einstellvorrichtung (209) zum Bewegen von mindestens einer der Kathode oder des Schutzschildes vorgesehen ist, basierend auf dem Erfassungssignal, um einen vorbestimmten Abstand in der Richtung der Abnahme des Unterschieds des Abstandes zwischen der Verdampfungsoberfläche der Kathode und der oberen Kante des Schutzschildes.

2. Ein Beschichtungssystem gemäß Anspruch 1, wobei die Einstellvorrichtung dazu angepaßt ist, eine Kathodenstützplatte (24), die an einem Leiter (8) befestigt ist, zu bewegen, die die Kathode (11) stützt und Einstellmuttern (23) zum Montieren der Stützplatte auf Stiftschrauben (22) umfaßt.

3. Ein Beschichtungssystem gemäß Anspruch 2, wobei Faltenbälge (25) zwischen der Kathodenstützplatte (24) und der Vakuumkammer (1) vorgesehen sind.

4. Ein Beschichtungssystem gemäß Anspruch 1, wobei die Einstellvorrichtung zur Bewegung der Kathode eine drehbare Vorrück-/Zurückziehwelle (201) aufweist, die unterhalb der Kathode angeordnet ist, und eine ringförmige Stützplatte (202), die mit der Welle (20) verschraubt ist und an der Vakuumkammer (231) befestigt ist, wodurch eine Einstellung durch Drehen der Welle bewirkt wird.

5. Ein Beschichtungssystem gemäß einem der Ansprüche 1 bis 4, wobei sich das Schutzschild (31b) über eine Umfangskante der Verdampfungsoberfläche (111) der Kathode hinaus erstreckt.

6. Ein Beschichtungssystem gemäß Anspruch 5, wobei die Kathode und das Schutzschild koaxial sind, das Schutzschild einen zylindrischen Abschnitt (31a) hat, der den Umfang der Kathode (11) mit einem Spalt dazwischen umgibt, und ein Kantenschutzschildabschnitt (31b) von einer oberen Kante des zylindrischen Schutzschildabschnitts (31a) vorsteht, um mit einem Umfangsrand der Verdampfungsoberfläche (111) von oben zu überlappen.

7. Ein Verfahren zur Steuerung eines Kathodenzerstäubungsbeschichtungssystems, aufweisend eine Kathode (11, 205), die aus einem filmerzeugenden Material hergestellt ist, ein Schutzschild (13, 27, 31, 206) zum Umgeben der Kathode, mit einem Spalt (C, D, Y), und eine Vakuumkammer (1, 231), die die Kathode und das Schutzschild enthält, wobei das System dazu angepaßt ist, ionisierte Kathodensubstanz durch Verdampfen der Kathodensubstanz von einer Verdampfungsoberfläche (111) der Kathode durch Lichtbogenentladung in der Kammer auf die Oberfläche eines Substrats zu schichten, gekennzeichnet durch
Erfassen der Zahl an Lichtbogenstops über eine Zeitdauer,
Vorsehen eines Erfassungssignals (Z), wenn die erfaßte Lichtbogenstopanzahl einen vorbestimmten Wert erreicht, und
Einstellen der relativen Position einer oberen Kante des Schutzschildes und der Verdampfungsoberfläche der Kathode, basierend auf dem Erfassungssignals.

## Revendications

1. Système de dépôt par pulvérisation cathodique conçu pour évaporer et ioniser une substance de cathode à partir d'une surface d'évaporation (111) d'une cathode (11) au moyen d'une décharge d'arc et pour ioniser celle-ci afin de la déposer sur la surface d'un substrat (5) ; ledit système comprenant :
une source d'évaporation par arc (S) comprenant une cathode (11, 205) fabriquée en matériau formant film, une électrode d'amorçage (208) pour redémarrer l'arc lorsque l'arc est arrêté, et un écran cylindrique (13, 31, 206) entourant la cathode avec un espace (C, D, Y) entre eux, aligné et disposé de telle sorte que le bord supérieur (13cu, 27bu, 31bu, 206bu) de celui-ci soit sensiblement à une hauteur identique de celle de la surface d'évaporation (111) de ladite cathode ;
caractérisé en ce qu'un dispositif de détection (211) est prévu pour détecter le nombre d'arrêts d'arc par unité de temps de ladite décharge d'arc et délivrer un signal de détection lorsque ledit nombre d'arrêts d'arc atteint un nombre prédéterminé, et des moyens d'ajustement (209) sont prévus pour déplacer au moins, soit ladite cathode, soit ledit écran, sur la base dudit signal de détection, d'une distance prédéterminée dans la direction permettant de diminuer la différence de distance entre la surface d'évaporation de ladite cathode et le bord supérieur dudit écran.

2. Système de dépôt par pulvérisation selon la revendication 1, dans lequel les moyens d'ajustement sont conçus pour déplacer une plaque de support de cathode 24 fixée à un conducteur (8) supportant la cathode (11), et incluent des écrous d'ajustement (23) pour monter la plaque de support sur des boulons filetés (22).

3. Système de dépôt par pulvérisation selon la revendication 2, dans lequel des soufflets (25) sont prévus entre la plaque de support de cathode (24) et l'enceinte à vide (1).

4. Système de dépôt par pulvérisation cathodique selon la revendication 1, dans lequel les moyens d'ajustement pour déplacer la cathode comprennent un arbre d'avancement/de retrait tournant (201) disposé au-dessous de la cathode et une plaque de support annulaire (202) accouplée par vissage à l'arbre (20) et fixée à l'enceinte à vide (231), si bien que l'ajustement s'effectue en faisant tourner ledit arbre.

5. Système de dépôt par pulvérisation selon l'une quelconque des revendications 1 à 4, dans lequel l'écran (31b) s'étend par dessus un bord circonférentiel de la surface d'évaporation (111) de ladite cathode.

6. Système de dépôt par pulvérisation selon la revendication 5, dans lequel la cathode et l'écran sont coaxiaux, l'écran a une partie cylindrique (31a) entourant la circonférence de la cathode (11) avec un espace entre eux et une partie d'écran de bord (31b) dépasse vers l'intérieur à partir d'un bord supérieur de la partie d'écran cylindrique (31a) pour chevaucher une marge circonférentielle de la surface d'évaporation (111) de dessus.

7. Procédé pour commander un système de dépôt par pulvérisation cathodique comprenant une cathode (11, 205) fabriquée en matériau formant film, un écran (13, 27, 31, 206) pour entourer la cathode avec un espace (C, D, Y) et une enceinte à vide (1, 231) enfermant ladite cathode et ledit écran, le système étant conçu pour déposer une substance de cathode ionisée sur la surface d'un substrat en évaporant la substance de cathode à partir d'une surface d'évaporation (111) de ladite cathode par décharge d'arc dans l'enceinte, caractérisé par
la détection du nombre d'arrêts d'arc sur une certaine période de temps,
la délivrance d'un signal de détection (Z) lorsque le nombre d'arrêts d'arc détecté atteint une valeur prédéterminée, et
l'ajustement de la position relative d'un bord supérieur dudit écran et de la surface d'évaporation de ladite cathode, sur la base dudit signal de détection.
